# EUROPÄISCHE PATENTANMELDUNG

(11) **EP 2 786 967 A1**
(43) Veröffentlichungstag der Anmeldung: **08.10.2014**
(21) Anmeldenummer: 13162162.5
(22) Anmeldetag: 03.04.2013
(51) Int. Cl.: C01F 11/18, B01J 8/20, B01J 8/22

(54) **Verfahren und Anlage zur Herstellung von kristallinem Calciumcarbonat unter kombinierter Verwendung zweier Gase mit unterschiedlichem CO2-Gehalt**

(71) Anmelder: HF Biotec Berlin GmbH, 10117 Berlin (DE)
(72) Erfinder: Follmann, Heinrich, 10117 Berlin (DE); Hillbrecht, Berit, 15366 Hoppegarten (DE)
(74) Vertreter: Gulde & Partner

(57) **Zusammenfassung**

Die Erfindung betrifft ein besonders energieeffizientes, zweistufiges Verfahren und eine Anlage zur kontinuierlichen oder semikontinuierlichen Herstellung von kristallinem Calciumcarbonat (gefälltes Calciumcarbonat, PCC) durch Umsetzung von Calciumhydroxid mit CO₂, wobei das Calciumhydroxid als Kalkmilch bereitgestellt wird. Als CO₂-Quelle dient in der ersten Stufe der Keimbildung ausschließlich Rauchgas mit einem CO₂-Gehalt von 4-25%. In der zweiten Stufe wird der vollständige Umsatz der in der ersten Stufe maximal zu 90%, vorzugsweise von 10 bis 90%, umgesetzten Kalkmilch ausschließlich unter Verwendung eines Starkgases, das 30 bis 99% CO₂ aufweist, betrieben, vorzugsweise unter Verwendung von Biogas.

## Beschreibung

Die Erfindung betrifft ein besonders energieeffizientes, zweistufiges Verfahren und eine Anlage zur kontinuierlichen oder semikontinuierlichen Herstellung von kristallinem Calciumcarbonat, (gefälltes Calciumcarbonat, PCC) durch Umsetzung von Calciumhydroxid mit CO₂, wobei das Calciumhydroxid als Kalkmilch bereitgestellt wird. Als CO₂-Quelle dient in der ersten Stufe der Keimbildung ausschließlich Rauchgas mit einem CO₂-Gehalt von 4-25%. In der zweiten Stufe wird der vollständige Umsatz der in der ersten Stufe maximal zu 90%, vorzugsweise von 10 bis 90%, umgesetzten Kalkmilch ausschließlich unter Verwendung eines Starkgases, das 30 bis 99% CO₂ aufweist, betrieben, vorzugsweise unter Verwendung von Biogas.

Das erfindungsgemäße Verfahren bewirkt zudem die simultane Reinigung des vorzugsweise eingesetzten Biogases, das durch Abreicherung des CO₂ zu Biomethan aufgereinigt wird. Das mit dem erfindungsgemäßen Verfahren erhaltene Biomethan weist vorzugsweise noch einen CO₂-gehalt von 0,1 bis 3% auf.

Mit dem erfindungsgemäßen Verfahren und der dazugehörigen Anlage lässt sich bedarfsgerecht, unabhängig von Schwankungen in der Bereitstellung des Starkgases, z. B. des Biogases, durch zusätzliche Verwendung von Rauchgas stets die benötigte Menge von CaCO₃ in der gewünschten Morphologie mit besonders hohem energetischen Wirkungsgrad und besonders großer volumetrischer Produktivität herstellen.

Nach Stand der Technik ist eine Vielzahl von Verfahren bekannt, bei denen in wässriger Suspension aus Ca(OH)₂ unter Eintrag von CO₂ (üblicherweise aus Rauchgasen) PCC gebildet wird. Danach werden flüssiges CO₂ oder CO₂-haltige Rauchgase mit unterschiedlichen Belüftungssystemen in Kalkmilch eingetragen und häufig unter Zuhilfenahme von Additiven oder Impfkristallen die gewünschten Morphologie erzeugt. Großtechnisch wird üblichenrveise im Batch-Betrieb gearbeitet, wobei auch einige Verfahren einer kontinuierlichen PCC- Herstellung bekannt sind.

Beispielsweise beschreibt DE 199 43 093 A1 ein Verfahren zur kontinuierlichen Herstellung von CaCO₃, welches durch eine voneinander getrennte Keimbildungsphase und Keimwachstumsphase gekennzeichnet ist. Die Konzentration der Kalkmilch und das Mengenverhältnis Ca(OH)₂/CaCO₃ bestimmen danach die Kristallgröße. Energetische Aspekte bzw. die vollständige Ausnutzung des im Gasstrom enthaltenen CO₂ bleiben unbeachtet.

Aus EP 2 139 831 ist ein Verfahren zur Reinigung von Biogas bekannt, bei dem gleichzeitig CaCO₃ in kristalliner Form (PCC) entsteht und einer Vermarktung zugeführt werden kann. Bekannterweise führt dieses Verfahren zu zwei Möglichkeiten der Wertschöpfung - einspeisefähiges Biomethan und PCC in Form eines funktionalen Kristalls.

Rauchgase, die üblicherweise zur Herstellung von PCC benutzt werden, weisen im Gegensatz zu Biogas typischerweise einen deutlich geringeren CO₂-Gehalt auf. Die Herstellung von gefälltem Calciumcarbonat in standardmäßig batchweise durchgeführten Ansätzen ist energetisch aufwendig, da unabhängig von der Auswahl des CO₂-Eintragssystems eine große Menge von Inertgasen mit transportiert, verdichtet und eingetragen werden muss. In der industriellen Praxis wird die untere Grenze des wirtschaftlichen Betriebes mit Rauchgasen bei einem CO₂-Gehalt dieser Rauchgase von etwa 11% bis 15% gesehen. Es resultieren bei diesen geringen CO₂₋Gehalten der Rauchgase dann spezifische mittlere Energieverbrauchszahlen, die im Bereich der meist konventionellen Begasungsgeräte bei Werten von 170 kWh bis 190 kWh pro Tonne PCC liegen. Bei einem mittlerem Energiepreis von etwa 0,075 € pro kWh schlägt der Energiefaktor an dieser Stelle bereits mit circa 13 bis 14 € pro Tonne PCC zu Buche.

Ein weiterer Nachteil beim Einsatz von Rauchgasen liegt darin, dass diese vor Eingang in die Kompressorstufe auf circa 40°C gekühlt werden müssen. Würden die im Temperaturbereich von 80°C bis 110°C liegenden Rauchgase ungekühlt der Kompressorstufe zugeführt, würden nach notwendiger Kompression auf typischerweise 0,5 bis 0,7 bar Gastemperaturen weit oberhalb 120°C resultieren. Solch hohe Temperaturen führen aber bei allen bekannten Gaseintragssystemen auf Grund der Wasserdampfbildung zu Kavitation, was zu einem erheblich vermindertem Stoffeintrag führt. Eine Kühlung ist also unerlässlich, ist jedoch energieaufwendig und stellt somit einen zusätzlichen, nicht unerheblichen Kostenfaktor der PCC Produktion dar. Bei einer mittleren PCC onsite-Anlage, die mit umgerechnet circa 25.000 Nm³ Rauchgas betrieben wird, muss zur Abkühlung eine Kälteleistung von etwa 5 MW bis 6 MW aufgebracht werden, je nach Wasserdampfgehalt und Höhe der Eintrittstemperatur. Kostenmäßig schlägt sich dies zu Buche mit etwa 0,7 MW pro Tonne PCC oder was sich je nach Erzeugungsart der Kälteenergie mit etwa 6 € pro ton PCC (berechnet mit durchschnittlich 0,01 € pro kWh_{thermisch}) auswirkt. Bei einfachen skalenoedrischen Qualitäten im Einsatzbereich von Füllstoffen liegen die Erzeugerpreise lediglich bei 100 bis 120 €/t, somit repräsentieren die Kühlkosten an dieser Stelle bereits circa 5% der gesamten Produktionskosten.

Es ist deshalb die Aufgabe der vorliegenden Erfindung, ein Verfahren und eine Anlage zur besonders energieeffizienten Herstellung von gefälltem PCC zur Verfügung zu stellen. Gleichzeitig soll das Verfahren bzw. die Anlage so gestaltet sein, dass grundsätzlich jede vom Anwender gewünschte, definierte Kristallform hergestellt werden kann.

Die Aufgabe der Erfindung wird durch ein Verfahren gemäß Anspruch 1 und die besonderen Ausführungsformen der Unteransprüche gelöst. Das erfindungsgemäße Verfahren zur Herstellung von kristallinem Calciumcarbonat durch Umsetzung von Calciumhydroxid mit CO₂, wobei das Calciumhydroxid als Kalkmilch bereitgestellt wird und das Verfahren eine erste Stufe der Keimbildung der Calciumcarbonatkeime und eine nachfolgende, von der Keimbildung getrennte Stufe des Kristallwachstums umfasst, ist dadurch gekennzeichnet, dass
a) in der ersten Stufe die Keimbildung unter ausschließlicher Verwendung von Rauchgas, das 4 bis 25% CO₂ aufweist, in einem oder mehreren Reaktoren, deren Füllstände optional variabel sind, kontinuierlich betrieben wird, wobei die Parameter der Begasungsvorrichtung, die das Rauchgas in die Reaktoren einträgt, in Abhängigkeit vom Füllstand im jeweiligen Reaktor so eingestellt werden, dass 0,3 bis 5 m³ Gas/min/m³ Reaktorvolumen eingetragen werden, um in der ersten Stufe maximal 90% der Kalkmilch zu Calciumcarbonat umzusetzen, vorzugsweise 10 bis 90%,
b) in der zweiten Stufe Kristallwachstum und Kristallstabilisierung unter ausschließlicher Verwendung eines Starkgases, das 30 bis 99% CO₂ aufweist, in einem oder mehreren Reaktoren, deren Füllstände optional variabel sind, batchweise betrieben werden, wobei der vollständige Umsatz der teilumgesetzten Kalkmilch aus Stufe a) durch die voneinander unabhängige Einstellung der Parameter der Begasungsvorrichtung, die das Starkgas in die Reaktoren einträgt, im jeweiligen Reaktor gesteuert wird.

Das Verfahren ist also durch eine einstufig bis mehrstufig kontinuierlich betriebene Phase a) der Keimbildung gekennzeichnet sowie durch eine oder mehrere batchweise betriebene Stufe(n) b) der Kristallreifung und Kristallstabilisierung. Das Gesamtverfahren kann kontinuierlich oder semikontinuierlich geführt werden.

Die voneinander unabhängig einzustellenden Parameter der Begasungsvorrichtung sind in den Stufen a) und b) insbesondere die Begasungsrate und die Blasengröße. In einer bevorzugten Ausführungsform der Erfindung wird als Begasungsvorrichtung eine Begasungsturbine eingesetzt, insbesondere eine mit Vordruck arbeitende Turbine. In diesem Fall werden zur Steuerung der Begasung Vordruck und Drehzahl unabhängig voneinander eingestellt.

Stufe a) des erfindungsgemäßen Verfahrens wird unter ausschließlicher Verwendung von Rauchgas mit einem CO₂-Gehalt von 4 bis 25%, vorzugsweise 8 bis 20% und insbesondere bevorzugt von 11 bis 17% durchgeführt. Das erfindungsgemäß eingesetzte, CO₂-haltige Rauchgas ist ein Abgas, das bei der Verbrennung fossiler Brennstoffe oder Müll entsteht. Dieses fällt z. B. beim Kalk brennen, in Kraftwerken, Müllverbrennungsanlagen oder Hochöfen an.

Erfindungsgemäß wird das Rauchgas aus einem Rauchgassammler in den/die Reaktor(en) der Stufe a) mit 30-80°C eingespeist. Da Rauchgas industriell in der Regel mit ca. 80°C anfällt, wird es vorteilhafterweise mittels Wärmetauscher vor der Einleitung in den Rauchgassammler gekühlt und dekondensiert. Die dabei gewonnene thermische Energie kann z. B. zum Aufwärmen der Gärabläufe aus der Biogasproduktion in Vorbereitung der Stickstoffstrippung der Gärreste benutzt werden, insbesondere für den Fall, dass in Stufe b) des erfindungsgemäßen Verfahrens als Starkgas Biogas eingesetzt wird.

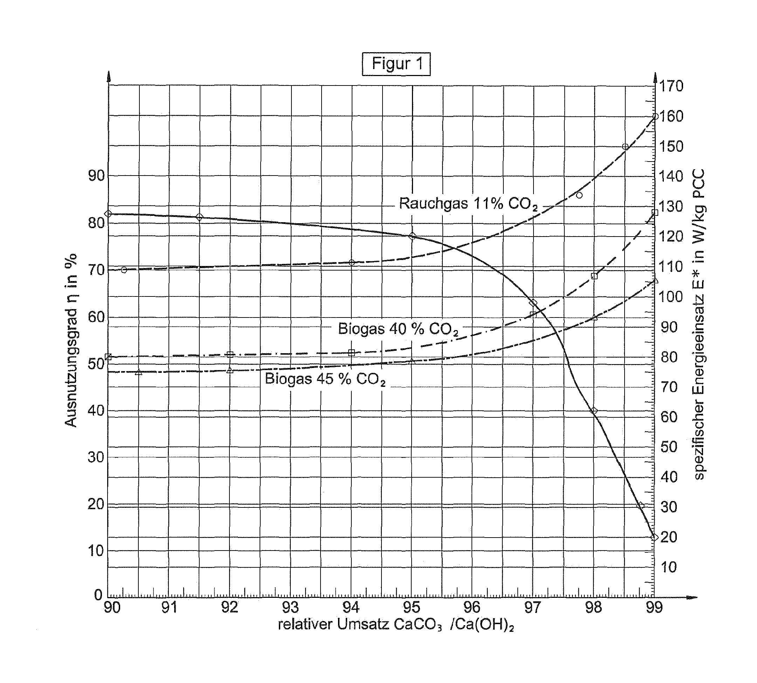

Das Rauchgas wird vorzugsweise mittels einer Begasungsturbine, die selbstsaugend oder mit Vordruck betrieben wird, vorzugsweise eine Turbine mit Vordruck der Firma Frings, Deutschland, in den/die Reaktor(en) der Stufe a) eingespeist. Vordruck und Drehzahl der Begasungsturbine werden in Abhängigkeit vom Füllstand im jeweiligen Reaktor so eingestellt, dass 0,3 bis 5 m³ Gas/min/m³ Reaktorvolumen eingetragen werden, so dass in der ersten Stufe lediglich 10 bis 90% der Kalkmilch umgesetzt werden. Es wird erfindungsgemäß strikt vermieden, die Reaktoren in einen Zustand eines Umsatzgrades von mehr als ca. 90% laufen zu lassen, da sich bei solch hohen Umsatzraten - ausgedrückt als Verhältnis von bereits gebildetem CaCO₃ zu noch vorhandenem Ca(OH)₂ - der energetische Wirkungsgrad rapide verschlechtert (vgl. Abbildung 1).

Vorzugsweise werden die Parameter der Begasungsvorrichtung in Abhängigkeit vom Füllstand in Stufe a) so eingestellt, das 1 bis 3 m³ Gas/min/m³ Reaktorvolumen eingetragen werden, besonders bevorzugt 1,5 bis 2,5 m³ Gas/min/m³ Reaktorvolumen. Im Fall der typischerweise eingesetzten Frings-Turbine werden die beiden Stromverbraucher Turbine und Verdichter also so aufeinander abgestimmt, dass bei jedem Füllstand ein maximaler Gaseintrag möglich ist.

Die Frings- Begasungsturbine arbeitet nach dem Rotor-Stator-Prinzip Die Flüssigkeit fließt in den Arbeitsbereich des Rotors ein und wird von diesem radial nach außen in die Statorkanäle geführt. Somit entsteht im inneren Bereich des Rotors ein Unterdruckbereich, in den das Gas eingesaugt wird. Das Gas wird dann in den Kanälen des Stators in einer turbulenten Strömung mit der Flüssigkeit dispergiert. Auf diese Weise vereint die Frings-Turbine die Aufgaben Mischen und Begasen in einer Apparatur.

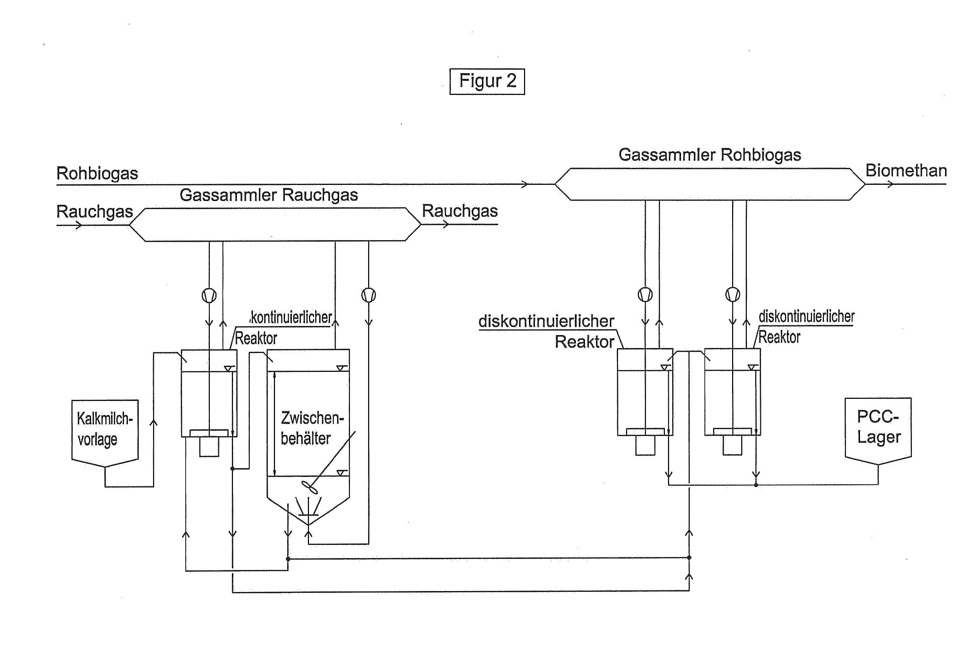

Das vorzugsweise Arbeiten mit variablem Füllstand in der kontinuierlich arbeitenden Stufe a) wird in einer Ausführungsform der Erfindung dadurch gewährleistet, dass einer oder mehrere Reaktoren in Stufe a) mit einem Zwischenbehälter verbunden sind (vgl. Fig. 2), der vorzugsweise das gleiche bis hundertfache des Volumens des mit ihm verbundenen kontinuierlich arbeitenden Reaktors aufweist, insbesondere bevorzugt das ein bis zwanzigfache des mit ihm verbundenen Reaktorvolumens. Der Zwischenbehälter ist auch mit dem/den Reaktoren der Stufe b) verbunden.

Dieser Zwischenbehälter kann, falls erforderlich, mit einem Rührwerk versehen sein und/oder einer Begasungsvorrichtung zum Eintrag von Rauchgas.

Das Rühren verhindert die Sedimentation der Partikel in der Suspension, die Begasungsvorrichtung verhindert die mögliche Umwandlung der bereits gebildeten Kristalle in andersartige Kristalle, die die Qualität und Homogenität des späteren Endproduktes negativ beeinflussen würden. Das Rühren und die Intensität der Begasung können so aufeinander abgestimmt werden, dass einerseits eine Rückreaktion mit Sicherheit vermieden wird, andererseits ein Reaktionsfartschritt erzielt wird, der klein ist im Verhältnis zur spezifischen Umsatzrate der vorangegangenen Stufe.

Aus diesem Zwischenbehälter wird nunmehr unabhängig von der kontinuierlich arbeitenden ersten Stufe die unvollständig umgesetzte Suspension in den/die Reaktoren der zweiten Stufe überführt, in der batchweise Kristallwachstum und Kristallstabilisierung unter Einstellung der gewünschten Parameter erfolgen.

Es ist erfindungsgemäß auch möglich, aus dem Zwischenbehälter einen Teilvolumenstrom abzuziehen und diesen in den letzten (oder einen der vorherigen) in der kontinuierlichen Stufe arbeitenden Reaktoren rückzuführen. Dies kann Vorteile bieten, wenn sich das Gasangebot verringert. Deshalb weist der Zwischenbehälter sowohl eine Hin- als auch eine Rückführung zum kommunizierenden kontinuierlichen Reaktor auf.

Der Zwischenbehälter dient somit als notwendiger Puffer für angelbetrieb bei Bereitstellung von CO₂-Äquivalenten einerseits, andererseits auch als ein im Füllstand variabel einstellbares Gefäß, welches bei einem Überangebot von CO₂ aufgefüllt werden kann.

In einer weiteren Ausführungsform der Erfindung kann die Einstellung des variablen Füllstandes für einen oder mehrere der kontinuierlich arbeitenden Reaktoren in Stufe a) durch volumetrische Vergrößerung des Reaktors/der Reaktoren mittels eines Aufsatzes auf den jeweiligen Reaktor erreicht werden, dessen Volumen vorzugsweise das gleiche bis zwanzigfache des unteren Teils des Reaktors beträgt. Die zusätzliche geodätische Höhe des Aufsatzes übersteigt die Arbeitshöhe des darunter angeordneten Reaktors vorzugsweise um den Faktor 1,2 bis 7. Besonders bevorzugt ist der Reaktor durch einen konischen Aufsatz vergrößert.

In einer Ausführungsform der Erfindung kann dieser Reaktoraufsatz in der folgenden Weise realisiert werden. Es wird im unteren Höhenteil des Reaktors ein Querschnitt gewählt, der auf die charakteristischen Auslegungskriterien der Begasungsturbine zugeschnitten ist. Die Höhe des Reaktors folgt dann im Verhältnis 0,5-2,0 den eigentlichen Auslegungskriterien der Turbine. Ab der Höhe von 0,5 bis 2,0-mal dem Durchmesser des unteren Teiles des Reaktors erfolgt zunächst eine konische Erweiterung des Querschnitts in einem Winkel von 15 bis 45° bis hin zum Erreichen eines Durchmessers von 1,5 bis 3-mal dem unteren Durchmesser. Es schließt sich ein weiterer Zylinder größeren Durchmessers an mit einer grundsätzlich beliebigen Höhle - vorzugsweise 1,5 bis 3-mal dem Wert des vergrößerten Durchmessers.

Anstelle dieser Ausführung kann auch ein durchgehend konischer Tank oder ein konischer Aufsatz zu Anwendung kommen, der auf dem unteren zylindrischen Teil aufsitzt. Letztendlich entsteht ein zusätzliches Volumen, das gegenüber dem unteren zylindrischen Teil des Reaktors um den Faktor 1 bis 20 mal größer ist. Der in dieser Ausführungsform notwendigerweise höhere Vordruck des Gasversorgungsstromes kann stufenweise dem Füllstand angepasst werden. Im unteren Teil des Reaktors herrschen hinsichtlich Stoffübergang, Vermischung und Umlaufzahl der Flüssigkeit die definierten und beherrschbaren Verhältnisse. Im oberen Teil des Reaktors dominieren Zustände geringer Vermischung und schwächeren Stoffüberganges, die aber immer so eingestellt sind, dass eine Rückreaktion verhindert und gleichzeitig weiteres Kristallwachstum ermöglicht wird.

In der zweiten Stufe des erfindungsgemäßen Verfahrens wird die teilumgesetzte Kalkmilch aus der ersten Stufe in einem oder mehreren Reaktoren im Batchverfahren mit konstantem oder variablem Füllstand, vorzugsweise konstantem Füllstand, bis zum vollständigen Umsatz endcarboxyliert. Das in dieser Stufe benötigte CO₂ stammt ausschließlich aus einem Starkgas, das 30 bis 99% CO₂, vorzugsweise 30 bis 60% CO₂, insbesondere bevorzugt 30 bis 47% CO2 aufweist. Dieses Starkgas ist vorzugsweise Biogas, aber auch technisches Gas oder Rauchgas mit aufkonzentriertem CO₂-Gehalt sind anwendbar. Zum Aufkonzentrieren von Rauchgas, das weniger als 11% oder sogar weniger als 5% CO₂ enthält kann beispielsweise eine modifizierte Aminwäsche angewandt werden. In diesem Fall fällt ein Starkgas an, das bis zu 99 % CO₂ enthalten kann.

Auch der Eintrag des Starkgases in der zweiten Stufe des erfindungsgemäßen Verfahrens erfolgt bevorzugt mit Hilfe einer Begasungsturbine nach dem gleichen Konstruktionsprinzip wie oben beschrieben, die selbstsaugend oder mit Vordruck betrieben wird, und Vordruck und Drehzahl der Begasungsturbine werden unabhängig voneinander eingestellt. Der vollständige Umsatz des zur Verfügung gestellten CO₂ in der zweiten Stufe lässt sich insbesondere durch die voneinander unabhängige Einstellung von Drehzahl, Vordruck, Begasungsrate und anteilige Zumischung von Umluft in allen diskontinuierlichen Reaktoren steuern. Die Reaktoren der Stufe b) können auch mit einer anderen Begasungsvorrichtung deutlich einfacherer Bauart ausgerüstet sein.

Die Gasräume/Gassammler der Rauchgasstrecke sind von denen der Starkgasstrecke, insbesondere Biogasstrecke, hermetisch abgetrennt.

Die teilumgesetzte Suspension aus der ersten kontinuierlich betriebenen Stufe kann wie beschrieben in einen begasten oder unbegasten Zwischenbehälter gegeben werden, wenn vorübergehend die Kapazität des Starkgases, insbesondere Biogases, nicht ausreicht (vgl. z. B. Figur 2). Die teilumgesetzte Suspension aus der ersten Stufe kann alternativ auch in einen höheren Umsetzungsgrad gebracht werden, der jedoch immer weniger als 90% bezogen auf den Gesamtumsatzgrad beträgt.

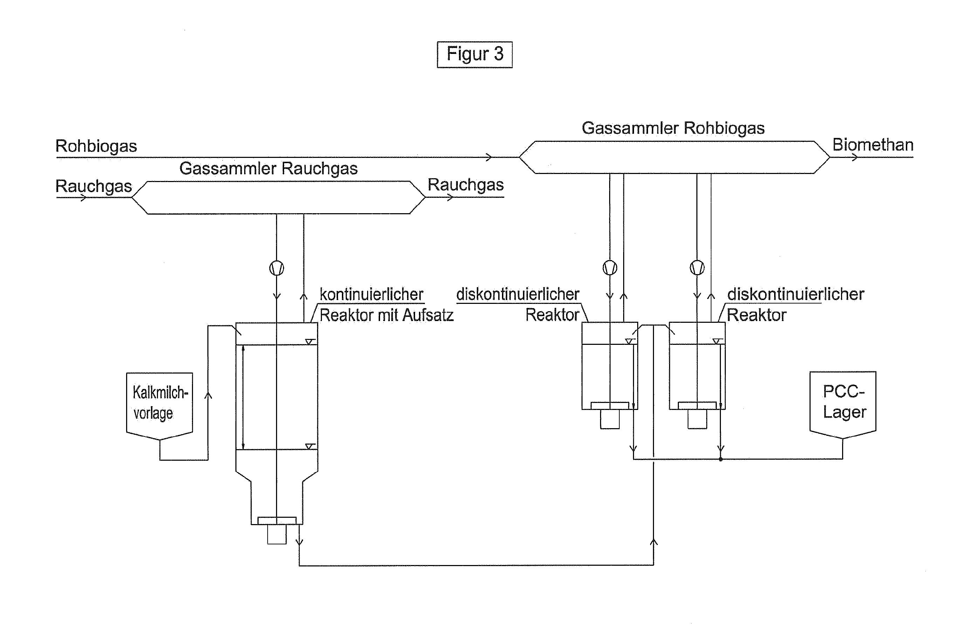

Die teilumgesetzte Suspension der ersten Stufe kann im gleichen Umsetzungsgrad gehalten werden, wobei der Füllstand erhöht wird und gegebenenfalls ein auf dem Reaktor befindlicher Aufsatz allmählich aufgefüllt wird (vgl. z. B. Figur 3).

Bei einem Überangebot von Starkgas, insbesondere Biogas, wird der Umsatzgrad in der ersten Stufe zurückgefahren, die mit einem geringeren Umsatzgrad versehene Suspension wird den Reaktoren der zweiten Stufe zugeführt, deren Kapazität wiederum durch Anheben des Füllstandes in Verbindung mit den verfahrenstechnischen Einstellungen des Gasdurchsatzes - z.B. höhere Drehzahl der Begasungsturbine - dergestalt angehoben werden kann, dass der geringere Teilumsatz aus der kontinuierlichen Stufe ausgeglichen wird.

Zur Herstellung gewünschter Kristallformen und Korngrößenverteilungen werden in den kontinuierlich arbeitenden Reaktoren der Stufe a), in denen sich die Keimbildung vollzieht, zusätzlich zu den Begasungsparametern vorzugsweise die nachfolgend genannten fünf Parameter unabhängig voneinander eingestellt. Dabei wird wie oben beschrieben ausschließlich Rauchgas eingesetzt. Es sind dies
- die Calciumhydroxidkonzentration der Kalkmilch und somit die relative Ionenstärke des Calcium- Kations,
- die mittlere hydraulische Verweilzeit der den Reaktor durchströmenden Kalkmilch, die somit das mittlere Alter der neugebildeten Keime festlegt,
- der Sättigungsgrad der Kalkmilch mit CO₂ und somit der resultierende Grad der Übersättigung des wirksamen Bicarbonatanions,
- der relative Umsatzgrad von Calciumhydroxid zu Calciumcarbonat, der sich aus der Kombination der Calciumhydroxidkonzentration der Kalkmilch in Verbindung mit der Durchsatzrate der Kalkmilch und schließlich in Verbindung mit den verfahrenstechnischen Charakteristika der Begasungsvorrichtung in einem Bereich von weniger als 10% bis 95% grundsätzlich stufenlos einstellen lässt, ablesbar an den korrespondierenden Werten der Leitfähigkeit und des pH-Wertes,
- die Reaktionstemperatur, die sich mittels eines in den Reaktor eingebauten Röhrenkühlers oder eines externen Kühlers auf jeden gewünschten Wert im Bereich von 5°C bis 80°C einstellen lässt.

Der Umsatzgrad von Calciumhydroxid mit CO₂ kann einerseits eingestellt werden über die Änderung der Calciumhydroxid-Konzentration in der vorgelegten Kalkmilch in Verbindung mit deren Feinheitsgrad und/oder über die Regulierung der elektrischen Leitfähigkeit der flüssigen Phase im Reaktor selbst. Es ist dem Fachmann bekannt, dass sich der Leitfähigkeitswert aus einer Kombination des hydraulischen Durchsatzes der Kalkmilch in Verbindung mit den Parametern der Begasungsvorrichtung einstellen lässt. Ein höherer Durchsatz der Kalkmilch führt zu höheren Leitfähigkeitswerten, da der Anteil an nicht abreagiertem Ca(OH)₂ steigt. Eine höhere Drehzahl der Turbine führt zu einem größeren Energieeintrag und somit zu einer größeren Oberfläche der Ca(OH)₂- Kristallite, was wiederum bewirkt, dass mehr Ca(OH)₂ in die Lösung nachgeliefert werden kann. Ein hoher Loitfähigkeitswert entspricht einer hohen Übersättigung an Ca(OH)₂ und umgekehrt. Es lassen sich Werte der Leitfähigkeit von 0,1 bis 7 mS/cm und mehr einstellen. Bekanntermaßen korrespondiert der jeweilige Wert für die Leitfähigkeit mit dem Umsatzgrad des Ca(OH)₂ zu CaCO₃. Hohe Umsatzraten im Fließgleichgewicht entsprechen geringen Leitfähigkeitswerten und umgekehrt. Die elektrische Leitfähigkeit wird beispielsweise mit einer handelsüblichen Sonde der Fa. Ahlborn oder WTW (Deutschland) gemessen.

Die mittlere hydraulische Verweilzeit der Kalkmilch in einem Reaktor der Stufe a) (=Verhältnis des Volumenstroms der zugeführten Kalkmilch zum Reaktorvolumen) lässt sich für jeden gewünschten Wert der Leitfähigkeit in einem weiten Bereich durch Anheben oder Absenken des Füllstandes des jeweiligen Reaktors einstellen.

Die Einstellung des Sättigungsgrades von CO₂ in der Kalkmilch, also die wirksame Konzentration an gelöstem CO₂ - dies entspricht dann der Bicarbonatanionenkonzentration - lässt sich im Reaktor der Stufe a) z. B. über die Veränderung des Füllstandes realisieren. Der Füllstand des Reaktors mit Kalkmilch kann in einem weiten Bereich (zwischen 30% und 100%) variabel gehoben und gesenkt werden. Dadurch steigt oder fällt die geodätische Höhe, die die Begasungsturbine überwinden muss. Bei ansonsten unveränderten Belüftungsdaten verbessert oder verschlechtert sich der KLA-Wert (Stoffübergangswert) und als Folge davon die Konzentration an gelöstem CO₂. Somit kann alleine über die Veränderung des Füllstandes der Grad der Übersättigung eingestellt werden. Zusätzlich kann noch die Drehzahl der Turbine geändert werden mit dem Ziel, den Effekt der Änderung des KLA-Wertes zu verstärken oder abzuschwächen.

Gegenstand der vorliegenden Erfindung ist auch eine Anlage zur Durchführung des erfindungsgemäßen Verfahrens. Die Anlage weist einen oder mehrere in Serie geschaltete kontinuierlich arbeitende Reaktoren auf, in denen maximal 90% der Kalkmilch zu Calciumcarbonat, umgesetzt wird, die ihrerseits mit einem oder mehreren diskontinuierlich arbeitenden Reaktoren verbunden sind, in denen die teilumgesetzte Kalkmilch aus den kontinuierlich betriebenen Reaktoren vollständig umgesetzt wird, wobei alle Reaktoren Begasungssysteme sowie Gaszuführungen und Gasrückführungen aufweisen, wobei die Gaszu- und -rückführungen den jeweiligen kontinuierlich arbeitenden Reaktor mit einem Rauchgassammler sowie den jeweiligen diskontinuierlich arbeitenden Reaktor mit einem Starkgassammler verbinden, und Rauchgassammler und Starkgassammler voneinander abgetrennt sind.

In einer Ausführungsform der Erfindung umfasst die Anlage einen oder mehrere in Serie geschaltete kontinuierliche Reaktoren (der Stufe a)), wobei mindestens einer der kontinuierlich arbeitenden Reaktoren durch eine Hin- und Rückleitung mit einem Zwischenbehälter verbunden ist und der/die kontinuierlichen Reaktoren ihrerseits sowie der oder die Zwischenbehälter mit einem oder mehreren in Serie geschalteten diskontinuierlich arbeitenden Reaktoren (der Stufe b)) verbunden sind. Der Zwischenbehälter weist vorzugsweise ein Rührwerk und/oder eine Begasungsvorrichtung sowie Gaszu- und rückführungen zum Rauchgassammler auf. Vorzugsweise ist der Zwischenbehälter mit zwei diskontinuierlich arbeitenden Reaktoren verbunden. Figur 2 zeigt die grundsätzliche Verschaltung.

In einer besonders bevorzugten Ausführungsform werden die Reaktoren der Stufe a) mit Rauchgas mit einem CO₂- Gehalt von 11 bis 17% versorgt, die Reaktoren der Stufe b) erhalten Biogas mit einem CO₂- Gehalt von typischerweise 30 bis 47%. Die Reaktionstemperatur der kontinuierlich arbeitenden Reaktoren wird mittels intern oder extern angeordneter Kühler auf einem konstanten Wert gehalten. Bei den diskontinuierlich betriebenen Reaktoren der zweiten Stufe kann ebenfalls die Reaktionswärme abgeführt werden. Es ist auch möglich, die Temperaturentwicklung frei laufen zu lassen bis sich ein Temperaturgleichgewicht aus der exothermen Reaktionswärme und Wärmeabstrahlung einstellt.

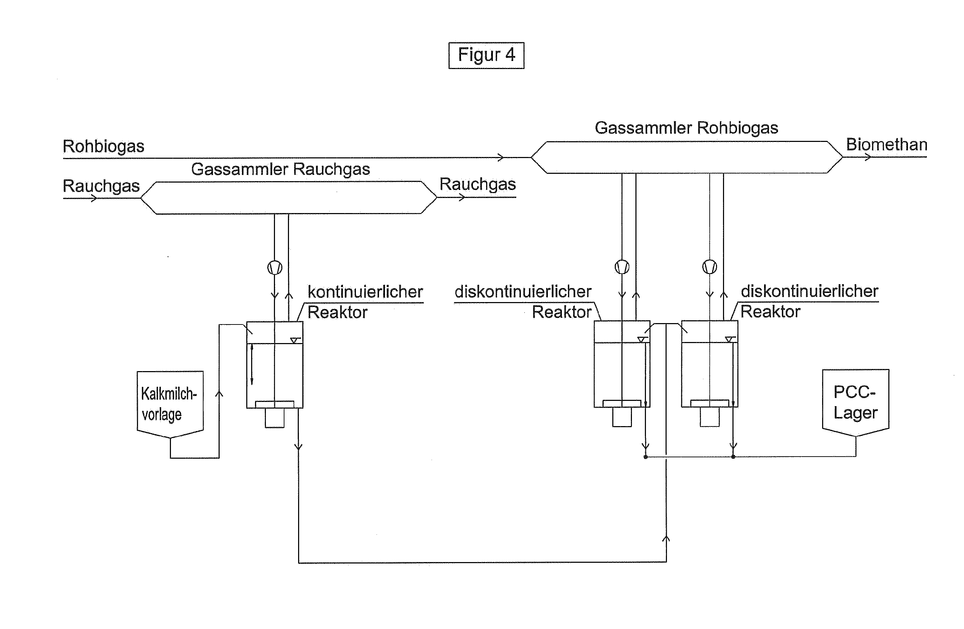

In einer anderen besonders bevorzugten Ausführungsform sind mehrere Batchreaktoren direkt mit den kontinuierlichen Reaktoren, die bei konstantem oder auch variablem Füllstand arbeiten, verbunden und werden nacheinander mit teilumgesetzter Kalkmilch aufgefüllt (vgl. Figur 4). Die kontinuierlich arbeitenden Reaktoren werden mit Rauchgas beschickt, das optional verdichtet wird, vorzugsweise auf ca. 300 mbar, die diskontinuierlich arbeitenden Reaktoren werden mit Biogas versorgt. Die Begasungsparameter sind, wie oben beschrieben, so eingestellt, dass bestimmungsgemäßes einspeisefähiges Biomethan entsteht.

Eine andere Ausführungsform ist in Abbildung 3 dargestellt. Sie weist einen kontinuierlich arbeitenden Reaktor auf, der mit einem Aufsatz zur Volumenvergrößerung versehen ist, der seinerseits direkt mit zwei diskontinuierlich arbeitenden Reaktoren verbunden ist. Das Volumen des Aufsatzes beträgt vorzugsweise das gleiche bis zwanzigfache des unteren Teils des Reaktors und die geodätische Höhe des Aufsatzes übersteigt die Arbeitshöhe des darunter angeordneten Reaktors vorzugsweise um den Faktor 1,2 bis 7. Die Begasung des kontinuierlich arbeitenden Reaktors erfolgt wiederum mit optional vorkomprimiertem Rauchgas. Das abreagierte Rauchgas verlässt den Reaktor durch eine separate Gasleitung und wird in die Atmosphäre ohne weitere Behandlungen abgeleitet. Die diskontinuierlichen Reaktoren werden wiederum mit Biogas versorgt.

Das erfindungsgemäße Verfahren ist nicht nur durch eine hohe Energieeffizienz gekennzeichnet, sondern es weist auch den großen Vorteil auf, dass ein temporär geringerer Anfall an Starkgas, z. B. ein geringerer Anfall an Biogas, durch ein mehr an Rauchgas kompensiert werden kann und umgekehrt bei einem Mehranfall an Biogas der zur Verarbeitung gelangende Anteil an Rauchgas entsprechend zurückgenommen werden kann. Mit dem erfindungsgemäßen Verfahren und der erfindungsgemäßen Anlage lassen sich technische Schwachgase wie z.B. Rauchgas in Kombination mit Starkgasen wie z.B. Biogas mit energetisch geringem Aufwand verarbeiten. Daneben lassen sich mit dem erfindungsgemäßen Verfahren auch alle industriell verlangten Modifikationen des CaCO₃ herstellen, z. B. scalenoedrisches Calcit, rhomboedrisches Calcit oder kubisches Nano-PCC oder auch aciculares Aragonit oder amorphes PCC oder basisches PCC.
Figur 1 zeigt die gemessene Abhängigkeit des Gasausnutzungsgrades vom relativen Umsatz CaCO₃/Ca(OH)₂ und die Abhängigkeit des spezifischen Energieeinsatzes vom relativen Umsatz CaCO₃/Ca(OH)₂ für einen im kontinuierlichen Betrieb arbeitenden Reaktor der Stufe a).
Figur 2 zeigt das Schema einer beispielhaften Anlage zur Durchführung des erfindungsgemäßen Verfahrens mit Zwischenbehälter.
Figur 3 zeigt das Schema einer beispielhaften Anlage zur Durchführung des erfindungsgemäßen Verfahrens mit konischem Reaktoraufsatz.
Figur 4 zeigt das Schema einer beispielhaften Anlage zur Durchführung des erfindungsgemäßen Verfahrens mit einem kontinuierlichem Reaktor, der bei konstantem oder variablem Füllstand arbeitet, und direkt mit mehreren diskontinuierlichen Reaktoren verbunden ist.

Nachfolgend wird die Erfindung an Hand von Beispielen genauer erläutert.

### Beispiel 1: Skalenoedrisches PCC (s-PCC)

Zur Herstellung von S-PCC wurde eine Anordnung mit Zwischenbehälter benutzt. Reaktor 1 wurde kontinuierlich mit einem Füllstand von 600 I betrieben. Der gewünschte Sättigungsgrad an Ca(OH)₂ wurde eingestellt, indem die durchschnittliche Verweildauer der Kalkmilch auf 2,6 h eingestellt wurde; die Leitfähigkeit betrug 5,2 mS/cm. Der Sättigungsgrad an CO₂ in der Lösung wurde über die Drehzahl der Turbine in Verbindung mit einem zugeschalteten Gebläse auf einen relativ geringen Wert (1180 rpm) eingestellt, was einem CO₂-Umsatzgrad von etwa 75% entsprach. Als Versorgungsgas diente Rauchgas mit einem CO₂- Gehalt von 17%.

Der Zwischenbehälter, dessen Volumen das dreifache Volumen des kontinuierlich betriebenen Reaktors besaß, wurde bis maximalen Volumen (1800 I) aufgefüllt. Danach wurde batchweise in den diskontinuierlich betriebenen Reaktor abgepumpt und die Reaktion dort zu Ende geführt. Hierbei kam Biogas mit 35% CO₂- Gehalt zur Anwendung. Ein Teil der Gasmenge wurde hier durch Umluft bereitgestellt.

Nachfolgend sind die Parameter für die Herstellung von S-PCC zusammengefasst:

| | |
|---|---|
| C_{Kalkmilch} | = 17 Gew% |
| t_{Kalkmilch} | = 20 °C (zu Beginn der Löschung) |
| d₅₀ der Calciumhydroxid-Kristallite | = 3,2 µm |
| volumetrischer Durchsatz _{Kalkmilch} | = 3,73 l/min |

### Stufe 1: kontinuierlich mit Rückführung über Zwischenbehälter Reaktorvolumen 600 l, ausgestattet mit selbstansaugender Begasungsturbine, unterstützt durch Gebläse, Gasdurchsatz 40 Nm³/h; Drehzahl auf 1180 rpm herabgesetzt durch Frequenzumformer

| | | |
|---|---|---|
| C _{CO2 ein} | = 17 % | (Rauchgas) |
| C _{CO2 aus} | = 4,25 % | |
| t | = 45 °C, | (konstant geregelt) |
| Umsatzrate U | = 45 % | |
| Durchschnittliche Verweilzeit | = 2,6 h | (bezogen auf Reaktor) |
| Durchschnittliche Verweilzeit | = 10,7 h | (bezogen auf Reaktor und Zwischenbehälter) |
| Leistung Transferpumpe von Reaktor in Zwischenbehälter und retour | = 30 l/h | |
| V_{Zwischenbehälter} | = 1800 l | (ausgestattet mit Becherrührwerk 1,5 kW) |

### Stufe 2: diskontinuierlich, Entnahme aus Zwischenbehälter

| | |
|---|---|
| V_{Reaktor} | = 600 l (ausgestattet mit Begasungsturbine mit Vordruck, Drehzahl = 1480 rpm/Vordruck per Gebläse |
| | = 100 mbar, mit Umluft |
| Gasdurchsatz | = 52 m³/h |
| C _{CO2 ein} | = 35 % |
| C _{CO2 aus} | = 20 % |
| Reaktionszeit | = 120 min |
| Starttemperatur | = 45 °C, ungeregelt |

### Nachbelüftung zur Stabilisierung:

| | |
|---|---|
| C _{CO2 ein} | = 35% |
| C _{CO2 aus} | = 33 % |
| Begasungsdaten identisch wie bei Stufe 2 beschrieben, Reaktionszeit: | = 0,17 h |
| Temperatur | = ungeregelt |

### Charakterisierung des Endproduktes:

- Morphologie: scalenoedrisch, aggregiert,d₅₀ 1,7 µm

### Charakterisierung der Energieverbrauchszahlen:

- spezifischer Energieverbrauch Stufe 1 bei kontinuierlichem Betrieb: 93 kWh / t CaCO₃
- spezifischer Energieverbrauch der Stufe 2 bei Batchbetrieb ohne Nachbegasung zur Stabilisierung:= 74 kWh / t CaCO₃
- spezifischer Energieverbrauch zur Nachbegasung, Lanzenbelüftung mit Rauchgas = 34 kWh / t CaCO₃

### Beispiel 2: Nano-PCC (n-PCC)

Zur Herstellung von Nano-PCC wurde eine Anordnung gewählt, bei der der Zwischenbehälter (der mit dem kontinuierlich betriebenen Reaktor 1 verbunden war) um den Faktor 21 größer war als Reaktor 1. Der Durchsatz der Kalkmilch wurde in Reaktor 1 so eingestellt, dass sich eine Leitfähigkeit von ca. 6 mS/cm ergab, was wiederum einer Verweilzeit der Kalkmilch von 0,44 h entsprach. Der CO₂-Sättigungsgrad war sehr hoch, bedingt dadurch, dass die Drehzahl der Turbine mit 1776 rpm gewählt wurde, und weiterhin dadurch bedingt, dass die Frischgaszufuhr angedrosselt wurde. Als Versorgungsgas wurde Rauchgas mit 24% CO₂- Gehalt gewählt.

Aus Reaktor 1, in welchem durch den gewählten Parametersatz die erzeugte Kristallmorphologie bestimmt wird, wurde kontinuierlich in den Zwischenbehälter gepumpt und dort aus batchweise in einem vom Volumen her betrachtet gleich großen weiteren Reaktor überführt. Dort wurde eine Kombination von stark reduzierter Drehzahl und Füllstand des Reaktors gewählt, so dass sich ein relativ schwacher CO₂- Umsatz ergab (76%). Zur Begasung wurde Biogas mit einem CO₂-Gehalt von 28% eingesetzt. Die Reaktion, gemeint hier Nachbegasung und Stabilisierung, wurde in einem weiteren extern angeordneten Reaktor zu Ende geführt. Hierfür wurde Biogas verwendet, das Begasungssystem war in diesem Falle eine selbstsaugende Turbine.

Nachfolgend sind die Parameter für die Herstellung von Nano-PCC zusammengefasst:

| | |
|---|---|
| C_{Kalkmilch} | = 7,2 Gew% |
| t_{Kalkmilch} | = 30 °C (zu Beginn der Löschung) |
| d₅₀ der Calciumhydroxid-Kristallite | = 2,0 µm |
| volumetrischer Durchsatz _{Kalkmilch} | = 22,5 l/min |

### Stufe 1: kontinuierlich mit Rückführung über zusätzlich begasten Zwischenbehälter

Reaktorvolumen 600 l, ausgestattet mit selbstansaugender Begasungsturbine

Drehzahl 1776 rpm; Begasungsrate 40 Nm3 / h

| | |
|---|---|
| Stromaufnahme Turbine: | = 27 kW |
| Spezifische Umsatzrate U: | = 30 % |
| C _{CO2 ein} | = 24% |
| C _{CO2 aus} | = 1,4% |
| Temperatur t: | = 25 °C, konstant geregelt |
| Umsatzrate U: | = 30% |
| Durchschnittliche Verweilzeit | = 0,44 h (bezogen auf Reaktor) |
| | = 9,8 h (bezogen auf Reaktor und Zwischenbehälter) |
| Transferpumpe von Reaktor in Zwischenbehälter und retour | = 10 l/h |
| V_{Zwischenbehälter} | = 12.600 I, ausgestattet mit Rührwerk 3 kW |
| Lanzenbelüftung mit 5 Nm3/h mit C _{CO2} | = 24 % (Rauchgas) |

### Stufe 2: diskontinuierlich, Entnahme aus Zwischenbehälter

| | |
|---|---|
| V_{Reaktor} | = 600 l, ausgestattet mit selbstansaugender Begasungsturbine (Drehzahl = 1184 rpm) /Begasungsrate 80 Nm³/h |
| Stromaufnahme Turbine | = 15 kW, |
| Stromaufnahme Gebläse | = 5 kW |
| C _{CO2 ein} | = 28 % |
| C _{CO2 aus} | = 13,7 % |
| Temperatur t | = 30 °C, konstant geregelt |
| Reaktionszeit | =1,5 h |

Nachbehandlung und Stabilisierung extern mittels selbstsaugender Turbine, Einsatz von Biogas, Spezialbehandlung.

### Charakterisierung des Endproduktes:

- Morphologie: mehr als 90 % calcitisch,
- Habitus: kubisch, leicht aggregiert, d₅₀ 130 nm

### Charakterisierung der Energieverbrauchszahlen:

- spezifischer Energieverbrauch Stufe 1 bei kontinuierlichem Betrieb: versorgt mit Rauchgas: 142 kWh / t CaCO₃
- spezifischer Energieverbrauch der Stufe 2 mit Biogas, bei Batchbetrieb ohne Nachbegasung zur Stabilisierung: 61 kWh / t CaCO₃
- spezifischer Energieverbrauch der Nachbegasung und Nachbehandlung mit Biogas und Turbinenbelüftung: 32 kWh / t CaCO₃

### Beispiel 3: rhomboedrisches PCC (r-PCC)

Zur Herstellung von rhomboedrischem PCC (r-PCC) wurde in der ersten kontinuierlichen Stufe ein Reaktor eingesetzt, auf dessen unteren Teil ein weiterer Behälter (Erweiterungskonus) aufgesetzt war, dessen Volumen 6,25 mal größer war als das des darunterliegenden Reaktors. Der untere Teil des Reaktors besaß ein Arbeitsvolumen von etwa 3 m³, der Aufsatz fasste zusätzliche 18,75 m³. Zur Begasung diente Rauchgas mit 17% CO₂. Es wurde eine niedrige Turbinendrehzahl (880 rpm) eingestellt. In Verbindung mit der zusätzlichen geodätischen Höhe des Aufsatzes ergab sich ein Ausnutzungsgrad des eingetragenen CO₂ von ca. 43,7%. Die Leitfähigkeit als Maß für die relative Sättigung des Systems an Ca(OH)₂ betrug 4,9 mS/cm. Dieser Wert ergab sich aus der Verweilzeit der Kalkmilch, die bezogen auf den unteren aktiven Teil des Reaktors etwa 0,33 h betrug. Die Verweilzeit, bezogen auf das gesamte Volumen des Reaktors betrug 2,4 h.

Aus dem oberen Teil des Erweiterungskonus wurde diskontinuierlich entnommen und in einem weiteren Reaktor mit einem Arbeitsvolumen von etwa 10 m³ die Reaktion zu Ende geführt. Die Parameter konnten hier in einem weiten Bereich ohne erkennbaren Einfluss auf die Kristallmorphologie variiert werden. Die Parameter der Turbine bestimmen letztlich den Zeitbedarf für diesen Teil der Reaktion. Auf diese Weise konnte der Zeitbedarf mit dieser Reaktoranordnung je nach Vorgaben des laufenden Betriebes zwischen 0,12 h und 0,2 h eingestellt werden. Die im Beispiel beschriebene Zeit von 0,12 h wurde erreicht bei einer Turbinendrehzahl von 1480 rpm im selbstsaugenden Betrieb ohne Hinzuschaltung eines Vordruckgebläses.

Nachfolgend sind die Parameter für die Herstellung von r- PCC zusammengefasst:

| | |
|---|---|
| Gewählter Branntkalk: | Produzent Felswerke Saal a.D. |
| C_{Kalkmilch} | = 13,0 Gew% (Ende der Löschung) |
| t_{Kalkmilch} | = 27 °C (Beginn der Löschreaktion) |
| d₅₀ der Calciumhydroxid-Kristallite | = 5,0 µm |
| volumetrischer Durchsatz _{Kalkmilch} | = 153 l/min |
| C_{CO2} (Rauchgas) | = 17 % (Eingangskonzentration) |

### Stufe 1: kontinuierlich mit aufgesetztem Reaktorteil der im Durchmesser erweitert ist, unterer Reaktorteil mit gebläseunterstützer Turbine begast, Begasungsrate 2200 Nm³/h, Drehzahl = 888 rpm, Kraftbedarf für Turbine: 65 kW, Kraftbedarf für Gebläse: 35 kW.

| | |
|---|---|
| V_{Reaktor} : | unterer Teil des Reaktors |
| | = 3000 l (Höhe 1,9 m) |
| | oberer Teil des Reaktors; incl. Erweiterungskonus |
| | = 18750 l (Höhe_{Gesamt} 2,5 m) |
| C _{CO2 ein} | = 17 % (Rauchgas) |
| C _{CO2} aus | = 7,42 % |
| Temperatur t | = 20 °C, konstant geregelt |
| Umsatzrate U | = 58,2 % |
| durchschnittliche Verweilzeit | = 0,33 h (bezogen auf unteren Reaktorteil) |
| | = 2,4 h (bezogen auf Gesamtvolumen) |

### Stufe 2: diskontinuierlich, Entnahme von teilweise umgesetzter Suspension aus dem oberen Teil des Reaktors,

| | |
|---|---|
| V_{Reaktor} : | = 10.000 l |
| egasung mit selbstansaugender Turbine, Begasungsrate 3000 Nm³/h, Drehzahl 1480 rpm, Motor mit Kraftaufnahme von 185 kW | |
| C _{CO2 ein} | = 47 % (Biogas aus Sammler vorderer Teil) |
| C _{CO2 aus} | = 4,6 % |
| Temperatur | = 20 °C zu Reaktionsbeginn, danach ungeregelt |
| Reaktionszeit | = 9 min |

Nachbegasung zur Stabilisierung in externem Reaktor = 6 min mit einfacher Lanzenbelüftung .

| | |
|---|---|
| C _{CO2 ein} | = 17 % (Rauchgas) |
| C _{CO2 aus} | = 16 % |

### Charakterisierung des Endproduktes:

- Morphologie: rhomboedrisch, leicht aggregiert,
- d₅₀ : 1,7 µm
- BET Oberfläche: 8 m²/g

### Charakterisierung der Energieverbrauchszahlen:

- spezifischer Energieverbrauch Stufe 1 bei kontinuierlichem Betrieb: versorgt mit Rauchgas: 88 kWh / t CaCO₃
- spezifischer Energieverbrauch der Stufe 2, mit 47 % Biogas, bei Batchbetrieb ohne Nachbegasung zur Stabilisierung: 57 kWh /t CaCO₃
- spezifischer Energieverbrauch der Nachbegasung mit Rauchgas und Lanzenbelüftung: 25 kWh /t CaCO₃

### Energetische Ausnutzung des Rauchgases vor Kompression und vor Einleiten in die Reaktoren:

- Rauchgasmenge: 2200 Nm³ mit 44 % H₂O- Gehalt entsprechend 320 g/m³ 11 % CO₂, Temperatur nach Verlassen der Öfen: 88 °C.
- Rauchgas nach Abkühlung auf 40 °C: H₂O Gehalt 51 g/m³, CO₂-Konzentration 17,6 %,
- Wärmegewinn durch Herabkühlen auf 40 °C = 412 kWh
- Nutzung dieser Wärme zum Erwärmen von 8,4 m³ Gärabläufen von 28 °C auf 70 °C, ohne Wärmerückgewinnung, Bedarf: 410 kWh,
- Die erwärmten Gärabläufe wurden vorteilhaft einer NH₃- Strippung zugeführt.

### Beispiel 4: aciculares PCC (Rauchgas mit 11 % CO₂ kontinuierlich, Biogas 47 % CO₂ diskontinuierlich)

Zur Herstellung von a- PCC wurde eine Anordnung gewählt, bei der ein großer, kontinuierlich betriebener Reaktor mit Rauchgas versorgt wurde. Von diesem Reaktor der ersten Stufe wurden nacheinander mehrere kleinere Reaktoren, die ihrerseits mit Biogas begast wurden, befüllt und batchweise abreagiert. Der Durchsatz der Kalkmilch wurde im kontinuierlichen Reaktor so eingestellt, dass sich ein relativer Umsatzgrad von Ca(OH)₂ zu CaCO₃ von 50% ergab, einer Leitfähigkeit von ca. 5,6 mS/cm entsprechend. Dies entsprach einer Verweilzeit der Kalkmilch von 0,8 pro h bei dem hier gewählten Datensatz. Die Begasungsturbine wurde in Kombination mit einem Gebläse betrieben, die Betriebsdaten von Begasungsturbine und Gebläse so aufeinander abgestimmt, dass zwar ein verhältnismäßig schwacher Wirkungsgrad des CO₂-Umsatzes resultierte, andererseits jedoch ein besonders günstiger energetischer Wirkungsgrad korrelierte.

Aus Reaktor 1, in welchem durch den gewählten Parametersatz, der Art und Weise der durchgeführten Löschung und dem ausgesuchten Branntkalk die erzeugte Kristallmorphologie bestimmt wird, wurde kontinuierlich direkt in mehrere kleinere Reaktoren überführt und dort batchweise der Rest der Carboxylierung inklusive der Nachbegasung durchgeführt. Hier wurden die Parameter der Begasung so gewählt, dass in einem Durchgang das Biogas in einem solchen Umfang von CO₂ befreit werden konnte, dass Netz-einspeisefähige Bedingungen resultierten. Die Nachbegasung wurde in diesem Falle in einem dritten Reaktor mit bereits abreagiertem Rauchgas durchgeführt.

Nachfolgend sind die Parameter für die Herstellung von a -PCC zusammengefasst:

| | |
|---|---|
| Gewählter Branntkalk: | Produzent Felswerke Saal a.D. |
| C_{Kalkmilch} | = 13,0 Gew% (Ende der Löschung) |
| t_{Kalkmilch} | = 30 °C (Beginn der Löschung) |
| d₅₀ der Calciumhydroxid-Kristallite | = 5,0 µm |
| volumetrischer Durchsatz _{Kalkmilch} | = 1,043 m3 / min |
| weitere Zusätze. | keine |
| Zusatz von Impfkristallen | keine |

### Stufe 1: kontinuierlich ohne Rückführung in zusätzlichen Zwischenbehälter Reaktorvolumen: 50 m³, ausgestattet mit selbstansaugender Begasungsturbine, 270 kW Leistungsaufnahme, getriebeuntersetzt, Abtriebsdrehzahl 700 upm, zusätzliches Gebläse, mehrstufig, Vordruck des verdichteten Rauchgases 320 mbar, Leistungsaufnahme des Gebläses: 105 kW,

| | |
|---|---|
| Begasungsrate | = 14.300 Nm³/h, |
| C _{CO2 ein} | = 11,0 % |
| C _{CO2 aus} | = 2,42 % |
| Temperatur t | = 60 °C, konstant geregelt |
| Umsatzrate U | = 50 % (relativer Anteil Ca(OH)₂ zu CaCO₃) |

### Stufe 2: diskontinuierlich, Kopfraumbegasung über Sammelrohr,

Reaktorvolumen: 14 m³, ausgestattet mit selbstsaugender Begasungsturbine, 185 kW Antrieb, mit zusätzlichem Gebläse, einstufig, Vordruck des verdichteten Biogases 150 mbar, Anschluss des Gebläses 34 kW , Abtriebsdrehzahl der Turbine: 1480 upm, Begasungsrate 4000 Nm³/h, Frischgasanteil 2000 Nm³/h,

| | |
|---|---|
| C _{CO2 ein} | = 45 % |
| C _{CO2 aus} | = 1,8 % |
| Temperatur t | = 60 °C, zu Beginn der Reaktion, danach ungeregelt, |
| Reaktionszeit | = 11 min |

Nachbegasung zur Stabilisierung = 0,1 h mit folgendem Datensatz:

| | |
|---|---|
| C _{CO2 ein} | = 9% |
| C _{CO2 aus} | = 8,1% |

Durchgeführt in externe Behälter mittels einfacher Lanzenbelüftung.

### Charakterisierung des Endproduktes:

- Morphologie: acicular, leicht aggregiert
- durchschnittliche Länge etwa 3,2 bis 3,6 µm
- durchschnittliche Breite etwa 0,4 bis 0,6 µm
- charakteristisches Verhältnis Länge zu Breite etwa 6,8

### Charakterisierung der Energieverbrauchszahlen:

- spezifischer Energieverbrauch Stufe 1, mit 11,0 % Rauchgas, bei Kontibetrieb: 71 kWh / t CaCO₃
- spezifischer Energieverbrauch der Stufe 2 (mit Biogas, 45 % CO₂) bei Batchbetrieb ohne Nachbegasung: 62 kWh / t CaCO₃

## Patentansprüche

1. Verfahren zur Herstellung von kristallinem Calciumcarbonat durch Umsetzung von Calciumhydroxid mit CO₂, wobei das Calciumhydroxid als Kalkmilch bereitgestellt wird und das Verfahren eine erste Stufe der Keimbildung der Calciumcarbonatkeime und eine nachfolgende, von der Keimbildung getrennte Stufe des Kristallwachstums umfasst,
**dadurch gekennzeichnet, dass**
a) in der ersten Stufe die Keimbildung unter ausschließlicher Verwendung von Rauchgas, das 4 bis 25% CO₂ aufweist, in einem oder mehreren Reaktoren, deren Füllstände optional variabel sind, kontinuierlich betrieben wird, wobei die Parameter der Begasungsvorrichtung, die das Rauchgas in die Reaktoren einträgt, in Abhängigkeit vom Füllstand im jeweiligen Reaktor so eingestellt werden, dass 0,3 bis 5 m³ Gas/min/m³ Reaktorvolumen eingetragen werden, um in der ersten Stufe maximal 90% der Kalkmilch zu Calciumcarbonat umzusetzen,
b) in der zweiten Stufe Kristallwachstum und Kristallstabilisierung unter ausschließlicher Verwendung eines Starkgases, das 30 bis 99% CO₂ aufweist, in einem oder mehreren Reaktoren, deren Füllstände optional variabel sind, batchweise betrieben werden, wobei der vollständige Umsatz der teilumgesetzten Kalkmilch aus Stufe a) durch die voneinander unabhängige Einstellung der Parameter der Begasungsvorrichtung, die das Starkgas in die Reaktoren einträgt, im jeweiligen Reaktor gesteuert wird.

2. Verfahren nach Anspruch 1,
**dadurch gekennzeichnet, dass**
das das in Stufe b) verwendete Starkgas Biogas, technisches Gas oder Rauchgas mit aufkonzentriertem CO₂-Gehalt ist, vorzugsweise Biogas.

3. Verfahren nach Anspruch 1 oder 2,
**dadurch gekennzeichnet, dass**
in Stufe a) mit variablen Füllständen gearbeitet wird.

4. Verfahren nach einem der Ansprüche 1 bis 3,
**dadurch gekennzeichnet, dass**
in Stufe b) mit konstanten Füllständen gearbeitet wird.

5. Verfahren nach einem der Ansprüche 1 bis 4,
**dadurch gekennzeichnet, dass**
die Einstellung eines variablen Füllstands für einen oder mehrere der kontinuierlich betriebenen Reaktoren in Stufe a) durch einen mit dem jeweiligen Reaktor kommunizierenden Zwischenbehälter gewährleistet wird, dessen Volumen vorzugsweise das gleiche bis hundertfache des Volumens des kontinuierlich betriebenen Reaktors beträgt, insbesondere bevorzugt das ein- bis zwanzigfache, und der mit dem/den Reaktoren der zweiten Stufe verbunden ist.

6. Verfahren nach Anspruch 5,
**dadurch gekennzeichnet, dass**
im Zwischenbehälter eine Begasungsvorrichtung zur Begasung der teilumgesetzten Kalkmilch mit Rauchgas vorgesehen ist und ein Rührwerk zum Rühren der Kalkmilch.

7. Verfahren nach einem der Ansprüche 1 bis 4,
**dadurch gekennzeichnet, dass**
die Einstellung eines variablen Füllstands für einen oder mehrere der kontinuierlich betriebenen Reaktoren in Stufe a) durch Reaktorvergrößerung mittels eines Aufsatzes auf den jeweiligen Reaktor gewährleistet wird, dessen Volumen vorzugsweise das gleiche bis zwanzigfache des Volumens des darunter angeordneten Reaktors beträgt.

8. Verfahren nach einem der Ansprüche 1 bis 7, **dadurch gekennzeichnet, dass** als Begasungsparameter in den Stufen a) und b) die Begasungsrate und die Blasengröße unabhängig voneinander eingestellt werden.

9. Verfahren nach einem der Ansprüche 1 bis 8, **dadurch gekennzeichnet, dass** die verwendete Begasungsvorrichtung in den Stufen a) und b) eine Begasungsturbine ist, vorzugsweise eine Begasungsturbine, die mit Vordruck betrieben wird.

10. Verfahren nach Anspruch 9, **dadurch gekennzeichnet, dass** in den Stufen a) und b) Vordruck und Drehzahl der Begasungsturbine unabhängig voneinander eingestellt werden.

11. Verfahren nach einem der Ansprüche 1 bis 10,
**dadurch gekennzeichnet, dass**
in Stufe a) die gewünschte Kristallform der Calciumcarbonatkristalle durch die voneinander unabhängige Einstellung der Calciumhydroxidkonzentration der Kalkmilch , der mittleren hydraulischen Verweilzeit der eingetragenen Kalkmilch, des Sättigungsgrades der Kalkmilch mit CO₂, des Umsatzgrades von Calciumhydroxid mit CO₂ und der Reaktionstemperatur gesteuert wird.

12. Anlage zur Durchführung des Verfahrens nach einem der Ansprüche 1 bis 11, aufweisend einen oder mehrere in Serie geschaltete kontinuierlich arbeitende Reaktoren, in denen maximal 90% der Kalkmilch zu Calciumcarbonat umgesetzt wird, die ihrerseits mit einem oder mehreren in Serie geschalteten diskontinuierlich arbeitenden Reaktoren verbunden sind, in denen die teilumgesetzte Kalkmilch aus den kontinuierlich betriebenen Reaktoren vollständig umgesetzt wird, wobei alle Reaktoren Begasungssysteme sowie Gaszuführungen und Gasrückführungen aufweisen, wobei die Gaszu- und -rückführungen den jeweiligen kontinuierlich arbeitenden Reaktor mit einem Rauchgassammler sowie den jeweiligen diskontinuierlich arbeitenden Reaktor mit einem Starkgassammler verbinden, und Rauchgassammler und Starkgassammler voneinander abgetrennt sind.

13. Anlage nach Anspruch 12,
**dadurch gekennzeichnet, dass**
mindestens einer der kontinuierlich arbeitenden Reaktoren einen Aufsatz aufweist, wobei das Volumen des Aufsatzes vorzugsweise das gleiche bis zwanzigfache des unteren Teils des Reaktors beträgt und die geodätische Höhe des Aufsatzes die Arbeitshöhe des darunter angeordneten Reaktors vorzugsweise um den Faktor 1,2 bis 7 übersteigt.

14. Anlage nach Anspruch 12,
**dadurch gekennzeichnet, dass**
mindestens einer der kontinuierlich arbeitenden Reaktoren durch eine Hin- und eine Rückführung mit einem Zwischenbehälter verbunden ist, der vorzugsweise mit einem Rührwerk und einer Begasungsvorrichtung sowie Gaszu- und -rückführungen zum Rauchgassammler versehen ist, und der Zwischenbehälter mit einem oder mehreren in Serie geschalteten diskontinuierlich arbeitenden Reaktoren verbunden ist, vorzugsweise mit zwei diskontinuierlich arbeitenden Reaktoren.
